Europäisches Patentamt

European Patent Office

Office européen des brevets

(11) Numéro de publication: **0 373 982**

**A1**

## (12) DEMANDE DE BREVET EUROPEEN

(21) Numéro de dépôt: **89403111.1**

(22) Date de dépôt: **10.11.89**

(51) Int. Cl.5: **G01R 1/08, G01R 15/12, G01D 7/00**

Le titre de l'invention a été modifié (Directives relatives à l'examen pratiqué à l'OEB, A-III, 7.3)

(30) Priorité: **14.11.88 FR 8814780**

(43) Date de publication de la demande: **20.06.90 Bulletin 90/25**

(84) Etats contractants désignés: **DE FR GB IT NL**

(71) Demandeur: **ITT COMPOSANTS ET INSTRUMENTS**
**157, rue des Blains**
**F-92220 Bagneux (Hautes de Seine)(FR)**

(72) Inventeur: **Lher, Pierre**
**Lotissement Charafine**
**FR-74410 Epagny/St Jorioz(FR)**
Inventeur: **Ernoult, Frédéric**
**56 Rue de Malaz**
**F-74600 Seynod(FR)**

(74) Mandataire: **Obolensky, Michel et al**
**c/o CABINET LAVOIX 2, place d'Estienne d'Orves**
**F-75441 Paris Cédex 09(FR)**

(54) **Appareil de mesure de différentes grandeurs électriques.**

(57) Appareil de mesure de différentes grandeurs électriques comprenant un cadran portant des échelles graduées (19) correspondant aux grandeurs que l'appareil est capable de mesurer, un indicateur à aiguille (16,17) déplaçable devant lesdites échelles graduées et des moyens comportant un microprocesseur (22) interposés entre l'entrée de l'appareil et l'indicateur à aiguille pour assurer les changements d'échelle de l'appareil en fonction de la nature et/ou de la plage de valeurs d'une grandeur à mesurer, caractérisé en ce que lesdites échelles graduées (19) sont réalisées à l'aide d'un dispositif d'affichage à cristal liquide connecté au microprocesseur (22) et commandé par celui-ci pour faire apparaître sur le cadran une seule échelle correspondant à la grandeur mesurée.

FIG. 1

EP 0 373 982 A1

## Appareil de mesure de différentes grandeurs électriques ou multimètre perfectionné.

La présente invention concerne les appareils de mesure de grandeurs électriques et se rapporte plus particulièrement aux appareils de mesure polyvalents couramment appelés multimètres.

Il existe des multimètres analogiques-numériques qui permettent comme leur nom l'indique de présenter les grandeurs mesurées sous forme analogique et/ou numérique.

Les appareils de mesure connus de ce type présentent pour la mesure de grandeurs analogiques des cadrans d'affichage pourvus d'un certain nombre d'échelles graduées devant lesquelles se déplace une aiguille.

Dans de tels appareils, c'est l'utilisateur qui détermine l'échelle qu'il doit utiliser pour lire la grandeur mesurée.

Le choix de l'échelle exige de l'utilisateur une attention soutenue de sorte que les risques d'erreurs de lecture sont assez importants en raison notamment du nombre d'échelles figurant sur le cadran et de la proximité relative de leurs graduations.

L'invention vise à remédier aux inconvénients des multimètres connus en créant un multimètre dont l'utilisation ne comporte plus aucun risque d'erreur de lecture.

Elle a donc pour objet un appareil de mesure de différentes grandeurs électriques comprenant un cadran portant des échelles graduées correspondant aux grandeurs que l'appareil est capable de mesurer, un indicateur à aiguille déplaçable devant lesdites échelles graduées et des moyens comportant un microprocesseur interposés entre l'entrée de l'appareil et l'indicateur à aiguille pour assurer les changements d'échelle de l'appareil en fonction de la nature et/ou de la plage de valeurs d'une grandeur à mesurer, caractérisé en ce que lesdites échelles graduées sont réalisées à l'aide d'un dispositif d'affichage à cristal liquide connecté au microprocesseur et commandé par celui-ci pour faire apparaître sur le cadran une seule échelle correspondant à la grandeur mesurée.

L'invention sera mieux comprise à l'aide de la description qui va suivre, donnée uniquement à titre d'exemple et faite en se référant aux dessins annexés, sur lesquels :

- la Fig.1 est un schéma synoptique d'un appareil de mesure suivant l'invention;
- la Fig.2 est une vue à plus grande échelle du cadran de l'appareil de mesure suivant l'invention;
- la Fig.3 est une vue analogue à celle de la Fig.2 sur laquelle n'apparait que l'échelle graduée de mesure des tensions avec une première sensibilité;
- la Fig.4 est une vue analogue à celle de la Fig.3 sur laquelle n'apparait que l'échelle graduée de mesure des tensions en millivolts avec une sensibilité plus importante;
- la Fig.5 est une vue analogue à celle de la Fig.4 sur laquelle n'apparaît que l'échelle de mesure graduée en décibels; et
- la Fig.6 est une vue analogue à la Fig.5 sur laquelle apparaissent des indicateurs d'alarme.

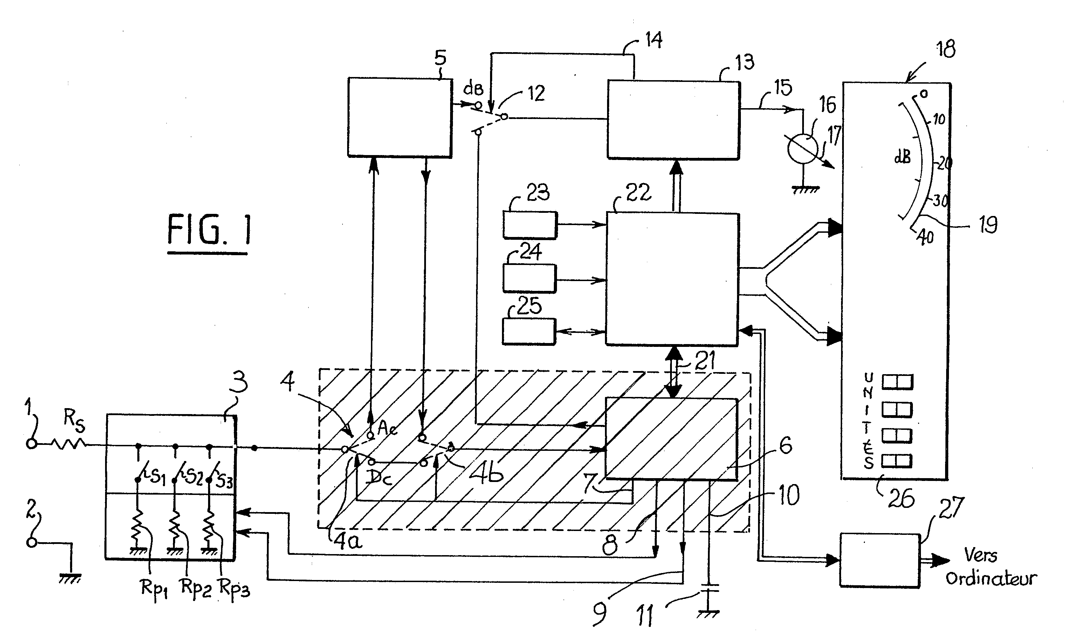

Le circuit de l'appareil suivant l'invention représenté à la Fig.1 comporte des bornes d'entrée 1, 2 auxquelles est destinée à être appliquée la grandeur à mesurer.

La borne d'entrée 1 est connectée à l'entrée d'un circuit adaptateur 3 constitué dans le présent exemple par un adaptateur résistif.

L'adaptateur résistif 3 comporte une résis tance série $R_s$ connectée à l'entrée 1 et des résistances Rp1 , Rp2, Rp3 connectées en parallèle entre la borne de la résistance $R_s$ opposée à l'entrée et la masse par l'intermédiaire de commutateurs S1, S2, S3.

Chaque résistance Rp constitue avec la résistance $R_s$ un diviseur de tension.

Que ce soit en mesure de tension ou de résistance, la commande analogique est du même type et consiste à mettre en service ou à isoler des résistances définissant la gamme utilisée.

L'exemple présenté sur la Fig.1 correspond à des mesures de tensions pouvant être continues ou alternatives et utilise l'atténuateur d'entrée composé des résistances Rp1 à Rp3 associées aux commutateurs S1 à S3 commandés d'une manière qui sera décrite par la suite.

La sortie de l'adaptateur 3 est connectée à un commutateur de fonction 4 permettant la mesure des tensions continues ou alternatives. Il est représenté schématiquement par deux commutateurs 4a, 4b.

La borne du commutateur 4a connectée à la sortie du circuit adaptateur 3 porte le contact mobile.

Un contact fixe AC du commutateur 4a est connecté à l'entrée d'un convertisseur AC/DC de tension alternative en tension continue 5, tandis que son autre contact fixe DC est connecté à un contact fixe correspondant du commutateur 4b.

L'autre contact fixe de ce dernier est connecté à la sortie du convertisseur AC/DC 5 tandis que son contact mobile est connecté à l'entrée d'un convertisseur analogique-numérique 6.

Une première sortie 7 du convertisseur 6 est une sortie de commande du commutateur 4.

Une seconde sortie 8 du convertisseur 6 est une sortie de production de courant pour le fonctionnement de l'appareil en ohmmètre, connectée à l'adaptateur 3.

Une troisième sortie 9 de ce convertisseur est une sortie de commutation de gammes connectée à l'adaptateur 3.

Une quatrième sortie 10 est connectée à un condensateur 11 constituant un élément de mémoire destiné au stockage et au maintien de valeurs de crête des grandeurs mesurées.

Selon le présent exemple, le rectangle en trait interrompu représente une pastille de circuit intégré comportant le convertisseur analogique-numérique 6, et le commutateur automatique de gammes 4.

Le convertisseur analogique-numérique 6 est en outre connecté par une sortie analogique ANO à un contact fixe d'un commutateur supplémentaire 12 dont un second contact fixe est connecté à la sortie dB du convertisseur AC/DC 5 et dont le contact mobile est connecté à l'entrée d'un circuit 13 d'interface analogique à gain variable.

Celui-ci comporte une première sortie 14 de commande du commutateur 12 et une seconde sortie 15 connectée à un indicateur à aiguille tel qu'un galvanomètre à cadre mobile 16 dont l'aiguille 17 est déplaçable devant un cadran 18 comportant plusieurs échelles graduées telles que 19 correspondant à diverses grandeurs à mesurer.

Les échelles graduées sont réalisées au moyen d'un dispositif d'affichage à cristal liquide constituant le cadran 18 dont l'éclairement assure l'apparition sur le cadran de l'échelle correspondant à la grandeur mesurée d'une manière qui sera décrite par la suite.

Le convertisseur analogique-numérique 6 est relié par un bus 21 à un microprocesseur de gestion 22 connecté à un clavier à touches 23 de commande de pas-sage de l'appareil en fonctionnement manuel et de sé- lection de fonctions particulières de celui-ci, à un commutateur rotatif 24 de sélection des grandeurs à mesurer et à une mémoire d'étalonnage 25.

Le microprocesseur de gestion 22 est en outre relié au circuit d'interface analogique 13 et au dispositif d'affichage à cristal liquide ou cadran 18 pour assurer d'une part la commande de l'apparition sur celui-ci des échelles graduées 19 et d'autre part la commande d'un dispositif d'affichage numérique 26. Il est enfin relié de façon interactive à un circuit 27 d'interface série d'étalonnage.

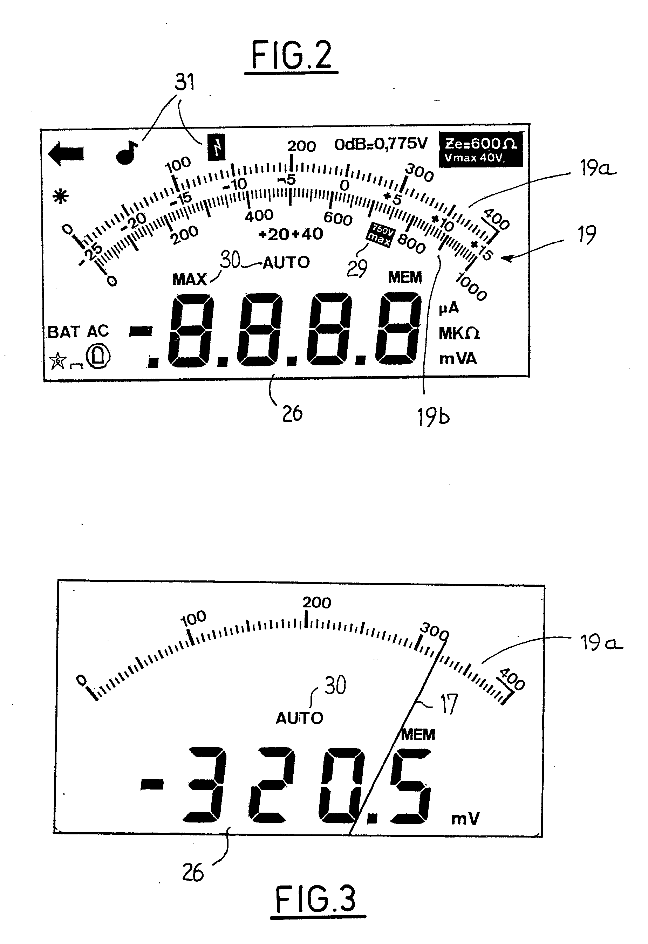

Sur la Fig.2, on a représenté à plus grande échelle un exemple de cadran entrant dans la constitution de l'appareil de mesure suivant l'invention.

Sur cette figure, toutes les échelles graduées 19 sont éclairées pour montrer les différentes possibilités de l'appaeil.

Le cadran qui n'est autre que le dispositif d'affichage à cristal liquide comporte une première échelle 19a de 0 à 400, une seconde échelle 19b de 0 à 1000 et une troisième échelle 19c de -25 à +15 ainsi que des indicateurs 28 d'unités en $\mu$ A , en $\Omega$ , K $\Omega$ , M $\Omega$ et en A, en V en mV et en mA, les unités apparaissant lors de l'éclairement des lettres correspondantes sous la commande du microprocesseur 22.

Le cadran comporte de plus des indicateurs 29 de capacité maximale de l'appareil, des indicateurs ou annonciateurs 30 de son mode de fonctionnement et des indicateurs 31 de signalisation et d'alarme indiquant en particulier lorsque le signal à l'entrée de l'appareil présente une valeur dangereuse, un indicateur de mise en service d'un dispositif de signalisation sonore et autre.

Au-dessous des échelles graduées 19 est placé le dispositif d'affichage numérique 26 du type à sept segments.

Le fonctionnement de l'appareil de mesure qui vient d'être décrit est le suivant.

La grandeur à mesurer est appliquée aux entrées 1 et 2, l'entrée 2 étant connectée à la masse.

Il peut s'agir d'une tension continue ou alternative, d'une température mesurée par une sonde ou de toute autre grandeur mesurable par le multimètre.

Si la grandeur est une tension continue, elle est tout d'abord adaptée à la dynamique du convertisseur analogique-numérique 6 par le circuit adaptateur 3.

Après adaptation, elle est appliquée par l'intermédiaire du commutateur 4, à l'entrée du convertisseur analogique-numérique 6 qui assure sa conversion sous forme numérique.

La borne ANO de ce convertisseur permet de disposer du niveau continu appliqué au convertisseur 6 pour pouvoir dans le cas présent exciter le galvanomètre 16 par l'intermédiaire du circuit d'interface 13 qui, sous la commande du microprocesseur 22, assure la commutation du commutateur 12 sur sa borne reliée à la sortie ANO du convertisseur analogique-numérique 6 et permet ainsi à la valeur analogique à mesurer de transiter par le circuit d'interface 13 vers le galvanomètre à cadre mobile 16.

Les informations numériques issues du convertisseur analogique-numérique 6 sont appliquées au microprocesseur 22 a qui en assure le traitement et décide des commandes à appliquer aux divers étages traversés par le signal mesure.

Il s'agit par exemple d'informations de gam-me pour l'atténuateur d'entrée 3 apparaissant sur la sortie 9 du convertisseur 6, d'informations d'orientation du signal suivant la fonction du multimètre, ainsi que de commandes destinées à la gestion de l'affichage.

En ce qui concerne l'information de gamme pour l'atténuateur d'entrée, la sortie 9 du convertisseur numérique 6 assure la commande des commutateurs S1 à S3 en fonction de la gamme choisie.

Le tableau ci-après donne un exemple de fonctionnement de l'atténuateur pour la mesure de tension.

| S1 | S2 | S3 | Résultat |
|----|----|----|----------|
| O | O | O | Entrée directe sur convertisseur 6 |
| F | O | O | Atténuateur 1 |
| O | F | O | Atténuateur 2 |
| O | O | F | Atténuateur 3 |
| avec F = commutateur fermé | | | |
| O = commutateur ouvert. | | | |

En ce qui concerne la commande des commutateurs analogiques S1 à S3, ils sont positionnés par des commandes électriques logiques de niveau 1 ou 0.

Ces commandes sont appliquées au convertisseur analogique-numérique 6 par le microprocesseur 22.

Le microprocesseur définit la gamme de mesure à utiliser en lisant à chaque fin de mesure, le résultat de la conversion du convertisseur analogique-numérique 6.

Pour une gamme de mesure donnée, trois cas peuvent se présenter :
- Dépassement de la pleine échelle O/R
- Mesure en-dessous d'un minimum appelé U/R
- Mesure entre les deux valeurs précédentes.

Si la mesure est en O/R, on change de gamme en augmentant l'atténuation à l'entrée de l'appareil.

Si la mesure est ≤ U/R, on change de gamme en diminuant l'atténuation à l'entrée de l'appareil.

Si la mesure est entre U/R et O/R, pas de modification de l'atténuation.

Le microprocesseur 22 commande en fonction de la nature de la grandeur mesurée et de la sensibilité exigée de l'appareil, l'allumage de l'échelle graduée 19 correspondante ainsi que des divers indicateurs ou annonciateurs 28 à 31 nécessaires à l'identification de l'échelle allumée et du mode de fonctionnement, de sorte que l'utilisateur de l'appareil n'a plus qu'à lire directement sur l'échelle graduée éclairée, la position de l'aiguille 17 du galvanomètre sans avoir à choisir parmi plusieurs échelles et plusieurs unités possibles.

L'affichage sur le dispositif à cristal liquide est commandé directement par le microprocesseur 22.

Simultanément à l'envoi au convertisseur analogique-numérique 6 des commandes d'atténuation, le microprocesseur 22 modifie les instructions destinées à la commande de l'apparition de telle ou telle échelle sur le dispositif d'affichage à cristal liquide, des indications chiffrées correspondant aux gammes de mesure et des indicateurs ou annonciateurs relatifs au mode de fonctionnement et aux signalisations de situations particulières.

Un tel agencement permet l'obtention de l'affichage direct de l'échelle de mesure analogique en même temps que l'affichage des unités, du point décimal et autres annonciateurs.

Simultanément sur l'afficheur numérique 26 apparaît la valeur numérique de la grandeur mesurée affectée éventuellement d'un signe - si la valeur mesurée est négative.

L'étalonnage du multimètre est assuré de façon numérique par stockage dans la mémoire d'étalonnage 25 des paramètres de correction liés à la gamme dans chaque fonction de l'appareil.

Le circuit d'interface série 27 permet d'effectuer cet étalonnage à partir d'un ordinateur de type PC (non représenté)

Les paramètres calculés par l'ordinateur à partir des informations qui lui sont transmises par le microprocesseur 22 par l'intermédiaire du circuit d'interface 27 sont transmis en retour au circuit d'interface 27 qui les inscrit dans la mémoire d'étalonnage 25.

La liaison entre le circuit d'interface série 27 et l'ordinateur est du type RS 232 et peut aussi être utilisée à d'autres fins, par exemple pour la commande à distance du multimètre. Elle pourrait également être de tout autre type approprié.

Dans l'exemple qui vient d'être décrit, le microprocesseur 22 utilisé est un microprocesseur spécialement conçu pour commander un dispositif d'affichage à cristal liquide. Il est par exemple du type NEC 7503 comportant des broches spéciales pour la commande d'un dispositif d'affichage à cristal liquide ainsi que tous les éléments nécessaires pour assurer une sélection d'affichage.

Le convertisseur 5 de tension alternative en tension continue est avantageusement du type AD 636 de la société ANALOG DEVICE.

Des exemples d'affichage réel à l'aide de l'appareil suivant l'invention vont être décrits en référence aux Fig.3 à 6.

Sur la Fig.3, l'appareil est en fonctionnement automatique de voltmètre sélectionné par le commutateur rotatif 24 (Fig.1).

La gamme déterminée par le microprocesseur 22 est de 0 à 400 mV et le microprocesseur a commandé l'éclairement de l'échelle 19a avec des indications numériques de 0 à 400.

L'aiguille 17 du galvanomètre 16 se trouve devant la division 320 de l'échelle.

L'afficheur numérique affiche - 320,5 mV continus, de sorte que l'indication de l'aiguille 17 est une indication de valeur négative.

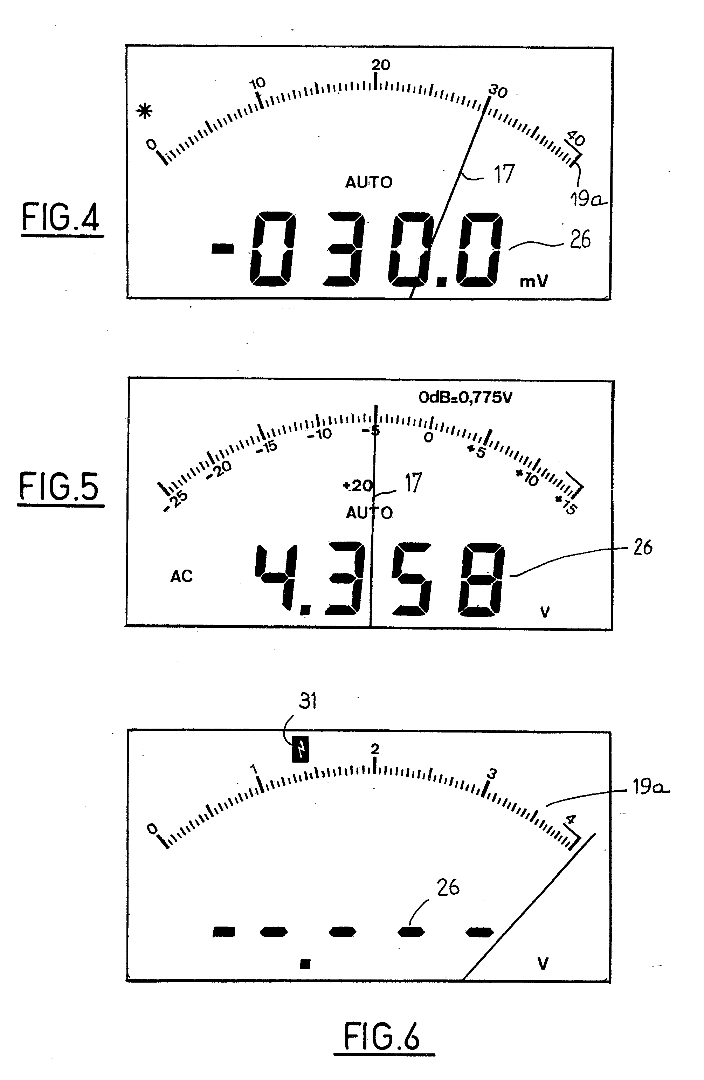

Sur la Fig.4 l'appareil est également en fonctionnement automatique de voltmètre.

Cependant, l'échelle 19a sélectionnée est maintenant affectée à des indications numériques de 0 à 40 mV de sorte que le microprocesseur 22 a procédé à une extension d'échelle analogique d'un facteur 10.

La valeur affichée par l'afficheur numérique est de - 030,0 mV continus.

Sur la Fig.5, l'appareil est placé en fonctionnement automatique de mesure en dB par l'aiguille 17.

Ce mode de fonctionnement a été sélectionné à l'aide d'une touche du clavier 23 qui a provoqué l'émission par le microprocesseur 22 d'une instruction vers le circuit d'inter face 13 en vue de la commutation du commutateur 12 sur la borne de sortie dB du convertisseur AC/DC 5.

L'afficheur numérique 26 indique 4,358 V alternatifs car l'indication AC apparaît sur le dispositif d'affichage à cristal liquide.

L'actionnement d'une autre touche du clavier 23 permet l'affichage de la valeur en dB sur l'afficheur numérique 26.

Sur la Fig.6, l'appareil fonctionne en voltmètre dans la gamme de 0 à 4 V.

L'aiguille 17 est au-delà de l'échelle 19a et l'afficheur numérique indique un dépassement sur la gamme du 0 à 4 V.

L'apparition de la flèche en forme d'éclair sur l'indicateur 31 signale un danger possible pour l'utilisateur et/ou l'appareil.

De la même manière, l'appareil peut sous la commande du microprocesseur fonctionner en ohmmètre, en ampèremètre, avec maintien en mémoire d'une valeur de crête affichée sur l'afficheur numérique 26, en a utomatique ou en manuel.

## Revendications

1. Appareil de mesure de différentes grandeurs électriques comprenant un cadran portant des échelles graduées 19) correspondant aux grandeurs que l'appareil est capable de mesurer, un indicateur à aiguille (16,17) déplaçable devant lesdites échelles graduées et des moyens comportant un microprocesseur (22) interposés entre l'entrée de l'appareil et l'indicateur à aiguille pour assurer les changements d'échelle de l'appareil en fonction de la nature et/ou de la plage de valeurs d'une grandeur à mesurer, caractérisé en ce que lesdites échelles graduées (19) sont réalisées à l'aide d'un dispositif d'affichage à cristal liquide connecté au microprocesseur (22) et commandé par celui-ci pour faire apparaître sur le cadran une seule échelle correspondant à la grandeur mesurée.

2. Appareil de mesure suivant la revendication 1, caractérisé en ce que le dispositif d'affichage à cristal liquide comporte également des indicateurs (28) des unités des grandeurs mesurées correspondant aux échelles (19) pouvant être affichées sous la commande du microprocesseur (22) , l'éclairement desdits indicateurs étant également commandé par le microprocesseur.

3. Appareil de mesure suivant l'une des revendications 1 et 2, caractérisé en ce que le dispositif d'affichage à cristal liquide comporte également des indicateurs (30) commandés par le microprocesseur et indiquant le mode de fonctionnement de l'appareil.

4. Appareil de mesure suivant l'une des revendications 1 à 3, caractérisé en ce que le dispositif d'affichage à cristal liquide comporte également ment des indicateurs (31) de signalisation et d'alarme commandés par le microprocesseur (22)

5. Appareil de mesure suivant l'une des revendications 1 à 4, caractérisé en ce qu'au microprocesseur (22) est associé un convertisseur analogique-numérique (6) connecté à l'entrée de l'appareil par l'intermédiaire d'un adaptateur (3) des signaux à mesurer et d'un commutateur de gammes (4), l'adaptateur (3) et le commutateur de gammes (4) étant commandés par le convertisseur analogique-numérique (6).

6. Appareil de mesure suivant la revendication 5, caractérisé en ce qu'au microprocesseur (22) est en outre associée une mémoire d'étalonnage (25) contenant des paramètres de corrections liés aux gammes de chaque fonction de l'appareil et un circuit d'interface série d'étalonnage (27) de liaison du microprocesseur (22) et de la mémoire d'étalonnage (25) avec un ordinateur de calcul des paramètres à partir des informations qui lui sont transmises par le microprocesseur (22)

7. Appareil de mesure suivant l'une des revendicatins 1 à 6, caractérisé en ce que le convertisseur analogique-numérique (6) comporte une borne (ANO) permettant d'appliquer à l'indicateur à aiguille (16, 17) la valeur analogique de la grandeur à mesurer qui lui est appliquée.

8. Appareil de mesure suivant l'une des revendications 5 à 7, caractérisé en ce qu'il comporte un convertisseur AC/AD (5) de tension alternative en tension continue connecté d'une part au commutateur de gammes (4) et d'autre part par l'intermédiaire d'un commutateur (12) relié à la borne de sortie-analogique (ANO) du convertisseur analogique-numérique (6), à un circuit d'interface analogique à gain variable (13) commandé par le microprocesseur (22) est relié à l'indicateur à aiguille (16,17).

FIG. 1

Vers Ordinateur

## FIG.2

## FIG.3

FIG.4

FIG.5

FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | US-A-4 174 500 (KUGA)<br>* Colonne 1, lignes 4-13; colonne 2, lignes 28-40; colonne 3, lignes 57-64; colonne 4, lignes 2-14; colonne 4, lignes 44-47; résumé; figures 1-10 *<br>--- | 1-5 | G 01 R 1/08<br>G 01 R 15/12<br>G 01 D 7/00 |
| Y | FR-A-2 596 870 (BBC)<br>* Page 1, lignes 14-23; page 9, lignes 26-35; figure 1 *<br>--- | 1-5 | |
| A | EP-A-0 114 536 (SOLOMAT S.A.)<br>* Page 3, lignes 20-35; page 5, ligne 29 – page 6, ligne 8; résumé; figures 1,2 *<br>--- | 1,2,5,6 | |
| A | TOUTE L'ELECTRONIQUE, no. 428, janvier 1978, pages 55-58; "Philips: le multimètre "PM 2524""<br>* En entier *<br>--- | 1,2,5,7 | |
| A | DE-A-2 700 593 (HÜTTNER)<br>* En entier *<br>--- | 1,2 | **DOMAINES TECHNIQUES RECHERCHES (Int. Cl.5)** |
| P,X | DE-A-3 732 144 (D. KNOLLMANN)<br>* En entier *<br>----- | 1-4 | G 01 R 1/00<br>G 01 R 13/00<br>G 01 R 15/00<br>G 01 D 3/00<br>G 01 D 7/00 |

Le présent rapport a été établi pour toutes les revendications

| Lieu de la recherche | Date d'achèvement de la recherche | Examinateur |
|---|---|---|
| LA HAYE | 21-02-1990 | TRELEVEN C. |